(19)

Europäisches
Patentamt
European
Patent Office
Office européen
des brevets

(11) **EP 3 054 307 A1**

(12) **EUROPEAN PATENT APPLICATION**

(43) Date of publication:
**10.08.2016 Bulletin 2016/32**

(51) Int Cl.:
**G01R 31/34** *(2006.01)*     *G01R 23/20 (2006.01)*

(21) Application number: **16150194.5**

(22) Date of filing: **05.01.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **23.01.2015 GB 201501133**

(71) Applicant: **Rolls-Royce plc**
**London SW1E 6AT (GB)**

(72) Inventors:
• **Athikessavan, Subash C**
  **120354 Singapore (SG)**

• **Nadarajan, Sivakumar**
  **118431 Singapore (SG)**
• **Gupta, Amit K**
  **650386 Singapore (SG)**
• **Panda, Sanjib K**
  **129792 Singapore (SG)**
• **Gajanayake, Chandana**
  **820647 Singapore (SG)**

(74) Representative: **Rolls-Royce plc**
**Intellectual Property Dept SinA-48**
**PO Box 31**
**Derby DE24 8BJ (GB)**

(54) **STATOR FAULT DETECTION AND DIAGNOSIS**

(57)     A method of detecting a stator fault in a multi-phase current induction machine comprises the steps of:

obtaining (S203) a respective frequency spectrum for each of the current phases in the induction machine;

deriving (S204), from each frequency spectrum, a value for the ITHD (Inverse current Total Harmonic Distortion) for the respective current phase;

calculating (S205) an ITHD deviation value corresponding to the maximum deviation for the derived ITHD values ;

judging (S206) whether the calculated ITHD deviation value differs from a reference deviation value; and

determining (S206), in response to a positive judgement, that there is a stator fault.

FIG. 2

## Description

Field of the Disclosure

The present disclosure relates to the detection and/or diagnosis of stator side faults in induction machines. In particular, but not exclusively, the present disclosure relates to a method and system for stator winding fault diagnosis and for distinguishing stator winding faults from voltage unbalance by analysing current harmonic distortions.

Background of the Disclosure

Electrical machines are widely being used in industrial applications, where more than 80% of rotating machines are induction machines, and are responsible for consuming around 50% of the total power generated in an industrialized nation. In addition, induction machines are also used in safety and mission critical applications such as actuators in aircraft and propulsion motors in marine vessels. Hence, it is important to improve the reliability and availability of such induction machines by the early detection of faults.

Electrical stress and thermal stress are the primary causes of faults in induction machines. If these faults are undetected at an early stage these faults can lead to electrical or mechanical failure, which in turn may cause permanent damage to the machine and excessive losses in revenue.

Stator winding faults are one of the most common electrical faults in induction machines, and contribute approximately 37% of total faults in induction machines. A key challenge involved in diagnosing stator winding faults in induction machines is that the fault signature of stator winding faults has similar characteristics to that of "voltage unbalance", so distinguishing the stator winding faults and voltage unbalance typically requires many signals and fault indicators for successful fault diagnosis.

For example, US8135551 discloses a system and method for identifying turn-to-turn short circuit faults in a motor stator winding. The disclosed method includes determining a normalized cross-coupled impedance from the symmetrical components of measured voltages and currents of the motor. Additionally, the normalized cross-coupled impedance is negative sequence impedance, which is determined through a regression analysis using parameters of the motor, such as line-to-line voltage, horsepower and number of poles. The disclosed system includes a device having a memory and processor configured to determine normalized cross-coupled impedance, to compare the normalized cross-coupled impedance to one or more thresholds, and to detect the turn-to-turn short circuit fault and then to trigger an alarm or to trip the motor.

In an alternative, US5514978 discloses the use of negative sequence current and voltage phasors to detect stator turn faults which are obtained through voltage and current measurement. Three arrangements are proposed for fault detection. In a first arrangement, an apparent negative sequence impedance is estimated by dividing the negative sequence voltage phasor by the negative sequence current phasor for comparison with a threshold negative sequence impedance. In a second related arrangement a current differential is estimated by dividing the negative sequence voltage phasor by characteristic negative sequence impedance and subtracting the result from the negative sequence current phasor for comparison with a threshold current differential. In a third related arrangement a voltage differential is estimated by multiplying the negative sequence current phasor by characteristic negative sequence impedance and subtracting the result from the negative sequence voltage phasor for comparison with a threshold voltage differential. The characteristic negative sequence impedance is said to be obtained by inserting a calibration device into one phase of the motor.

US6640196 discloses systems and methodologies for detecting faults and adverse conditions associated with electric motors. One such method comprises obtaining a current signal associated with the motor, calculating a space vector from the current signal, determining a space vector angular fluctuation from the space vector, and analysing the space vector angular fluctuation to detect at least one fault associated with the motor. The space vector angular fluctuation (SVAF) technique is also claimed to detect problems associated with unbalanced supply voltages, and to distinguish such faults from stator side faults. Two fault indicators are proposed: the $2f_s$ current component and the angular fluctuation of voltage space vectors.

Typically, these prior art techniques require both three phase current and three phase voltage measurements to permit detection and diagnosis of stator winding faults, and to be able to distinguish between stator winding faults and voltage unbalance. However, in most drive systems only current signals are typically measured for control purposes. Therefore, to implement condition monitoring systems (or to integrate condition monitoring algorithms with a drive controller) in conventional induction machines requires the addition of voltage sensors. This is undesirable as it incurs additional cost and requires modification and/or rewiring of the existing machines.

Summary of the Disclosure

Accordingly, the present disclosure provides a method of detecting a stator fault by using only multi-phase current of induction machine as set forth in Claim 1.

By contrast, the prior art mainly focuses on the negative sequence impedance to detect stator winding faults. But, the present inventors have realised that a key disadvantage of using negative sequence impedance is that the magnitude of negative sequence impedance depends on the machine load, hence there is an inherent difficulty associated with setting the threshold value for a healthy machine condition, and also a problem of diagnosing load transient as stator winding fault. However, the present disclosure provides a fault indicator (e.g. in the form of ITHD values and deviations) which is largely independent of machine loading, and hence the complexity associated with the load dependence can be overcome, and thus provides reliable fault detection and diagnosis.

Furthermore, in most drive systems only current signals are typically measured for control purposes. As the present disclosure only requires current measurements for fault detection and diagnosis, it is easy to integrate (retro-fit) to existing machines (e.g. with the drive controllers) without the need to fit additional sensors; whereas in the prior art voltage measurements are required which would typically incur additional cost and the need to modify the existing systems to fit voltage measurement devices.

Further still, as the proposed approach is (optionally) able to provide two level of fault diagnosis such that at a first level it is possible to distinguish between (diagnose) stator side and rotor side faults, and at a second level it is possible to distinguish between (diagnose) stator winding and voltage unbalance faults. Consequently, the robustness and efficacy of fault detection is higher than the prior art.

The present disclosure may be provided as a condition monitoring algorithm for execution on existing systems. Advantageously, the signals (e.g. measurements of the current flowing in each of the phases in the induction machine) which provide the data needed by the algorithm are typically already obtained by existing systems, e.g. for control purpose such as motor currents and speed for closed loop control speed/torque control.

Each method according to the present disclosure is preferably a computer implemented method.

In an aspect the present disclosure also provides a computer program, which when run on a computer executes any one (or more) of the methods disclosed herein.

In an aspect the present disclosure also provides a computer readable medium storing a computer program which when run on a computer executes any one (or more) of the methods disclosed herein. In an aspect, the present disclosure may be embodied by a computer incorporating the computer readable medium.

Brief Description of the Drawings

Embodiments of the disclosure will now be described by way of example with reference to the accompanying drawings in which:

Figure 1 shows a schematic, or block diagram, of an arrangement to which the present disclosure is applicable;

Figure 2 shows a flow chart demonstrating an embodiment of the present disclosure;

Figure 3 shows a flow chart demonstrating another embodiment of the present disclosure; and

Figure 4 shows a flow chart demonstrating another embodiment of the present disclosure, used in conjunction with aspects of prior art techniques.

Detailed Description and Further Optional Features of the Disclosure

In an aspect, the present disclosure proposes an approach to detect stator winding faults.

The present disclosure also proposes optional approaches to diagnose stator winding faults, to diagnose supply voltage unbalance, and to distinguish between stator side and rotor side faults.

Traditionally, the stator winding fault is detected by analysing the magnitude of stator winding fault characteristics frequency components in three phase currents. A key disadvantage in this method is the sensitivity to voltage unbalances, because the dominant frequency signature for the stator winding fault is similar to the voltage unbalance. Hence the prior art techniques typically measure three phase voltages to distinguish voltage unbalance from stator winding fault.

However, the present inventors have realised a method in which only the multi-phase or poly-phase (e.g. three phase) current measurements are used to reliably detect stator winding faults, and even to distinguish between stator winding fault and voltage unbalance.

Herein, for brevity, the disclosure is described with reference to three phase currents. However, the present disclosure is not limited in its applicability to three phase currents, and references to three-phase currents can be replaced with suitable references to multi-phase (polyphase) currents.

The proposed method is based on the harmonic distortion in measured multi-phase currents and can be referred to as a Inverse current Total Harmonic Distortion (ITHD) method.

The ITHD is calculated by dividing the magnitude of fundamental by the RMS value of all the harmonics (except the fundamental) whose magnitudes are greater than 1 % of the fundamental. Hence, it is the reciprocal of the conventional THD computation.

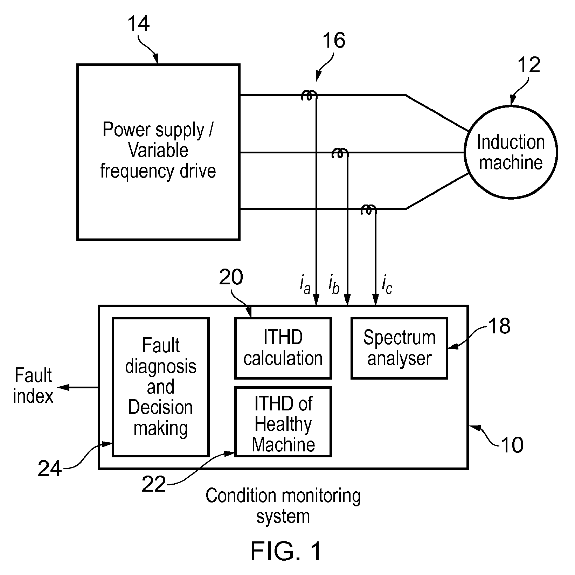

Figure 1 shows a block diagram of the proposed ITHD based condition monitoring apparatus 10 for an induction machine 12, supplied with electrical power by a power supply / variable frequency drive 14.

A respective current monitors or meter 16 is preferably provided to determine the current flowing through each of the lines supplied to the induction machine 12 by the power supply 14. In the example shown in Figure 1 the induction machine is a three phase induction machines, and thus there are three lines. Each line carries a respective phase current supplied to the induction machine 12. A skilled person understands how to achieve this.

The current meters 16 respectively supply a measurement result for the current measured in the each line, $i_a$, $i_b$ and $i_c$. The measurement results are supplied to the condition monitoring system 10.

The condition monitoring system includes a spectrum analyser 18, an ITHD calculation unit 20, a record 22 of a corresponding ITHD calculation for a healthy induction machine (preferably, the induction machine 12), and a fault diagnosis and decision making unit 24.

The condition monitoring system may be a computer. The record 22 may be stored in a memory of the computer. The record 22 may be a record of one or more ITHD reference values, and/or one or more ITHD average reference values, and/or one or more ITHD deviation values for comparison with corresponding calculated values as discussed below.

The spectrum analyser 18 may be provided in the computer as software, configured for example to generate a spectrum on the basis of the received currents measurements. The software may be configured to perform a Fourier transform to generate the desired spectrum or spectra. The Fourier transform may be a fast Fourier transform (FFT). The ITHD calculation unit 20 may be provided in the computer as software, configured to perform the ITHD calculations as described herein. The fault diagnosis and decision making unit 24 may be provided in the computer as software, configured to provide fault diagnosis and/or decisions in accordance with the fault diagnosis and/or decision making steps described herein. The computer may be provided with a processor for executing the respective software. The computer may be provided with memory for storing the software.

In a method according to the present disclosure, the three phase currents are measured e.g. by the meters 16. A respective FFT is produced for each of the three phase currents. The (non-fundamental) harmonic peaks which are greater than a predetermined magnitude of the fundamental peak (for example, 1% of the magnitude of the fundamental peak) are detected by a peak detection algorithm.

The threshold may be heuristic rather than a fixed predetermined value; any percentage value can be selected and varied until a suitable number of (non-fundamental) harmonics are detected. However, in practice, a value of 1% has proved successful.

The detected harmonic magnitudes are used to calculate the ITHD value for all the three phases by the below equation.

$$ITHD = \frac{I_{f1}}{\sqrt{\sum_{n=2}^{\infty} I_{fn}^2}}$$

Where, $I_{fl}$ is the magnitude of the peak of the fundamental harmonic, and $I_{fn}$ is the magnitude of the nth harmonic (excluding the fundamental harmonic). Note that the value $n$ in equation represents the selected harmonic order/components whose value is greater than the selected threshold, e.g. 1%, of the magnitude of the peak of the fundamental harmonic.

A simple definition for the ITHD is the ratio of the magnitude of the fundamental harmonic peak to the sum of the squared value of the magnitudes of the selected non-fundamental harmonic components. The ITHD values for each of the respective phase currents can be used, as discussed below, to detect and even diagnose stator side faults.

Table 1 below shows experimental results for the calculated ITHD value of three phase currents for (a) a healthy machine and (b) the same type and power rating machine with (i) rotor faults such as a broken rotor bar and (ii) bearing faults.

Table 1 - Comparison of ITHD average of three phase current under healthy and rotor side fault conditions.

| Load | ITHD / average ITHD value | Healthy | | | Bearing fault | | | Broken rotor bar fault | | |
|---|---|---|---|---|---|---|---|---|---|---|
| | | $i_a$ | $i_b$ | $i_c$ | $i_a$ | $i_b$ | $i_c$ | $i_a$ | $i_b$ | $i_c$ |
| 25% | ITHD | 18.69 | 22.00 | 20.05 | 18.39 | 22.14 | 19.62 | 18.07 | 21.97 | 19.67 |
| | average ITHD | 20.25 | | | 20.05 | | | 19.90 | | |
| 50% | ITHD | 18.62 | 19.64 | 24.51 | 18.32 | 19.37 | 23.60 | 18.88 | 20.58 | 22.96 |
| | average ITHD | 20.92 | | | 20.43 | | | 20.81 | | |
| 100% | ITHD | 20.19 | 19.58 | 22.86 | 19.97 | 19.43 | 23.30 | 20.88 | 21.49 | 27.68 |
| | average ITHD | 20.88 | | | 20.90 | | | 23.35 | | |

As will be appreciated the "average ITHD" is the average value of the ITHD calculated for each of the respective phase currents. So, for example, the average ITHD of the healthy machine under 25% load = (18.69+22.00+20.05)/3 = 20.25.

Table 2 below shows the calculated ITHD values of three phase current, and the resulting average, for (a) a healthy machine, (b) a machine with a stator winding fault and (c) a machine with a supply voltage unbalance.

Table 2 - Comparison of ITHD average of three phase current under healthy and stator side fault conditions

| Load | ITHD / ITHD average value | Healthy | | | Stator winding fault (5.5% of fault severity) | | | Voltage unbalance (4% of VU) | | |
|---|---|---|---|---|---|---|---|---|---|---|
| | | $i_a$ | $i_b$ | $i_c$ | $i_a$ | $i_b$ | $i_c$ | $i_a$ | $i_b$ | $i_c$ |
| 25% | ITHD | 18.69 | 22.00 | 20.05 | 14.95 | 10.26 | 21.35 | 14.60 | 12.96 | 15.26 |
| | ITHD average | 20.25 | | | 15.5 | | | 14.2 | | |
| 50% | ITHD | 18.62 | 19.64 | 24.51 | 15.34 | 11.21 | 22.32 | 12.14 | 9.91 | 14.43 |
| | ITHD average | 20.92 | | | 16.3 | | | 12.2 | | |
| 100% | ITHD | 20.19 | 19.58 | 22.86 | 15.71 | 11.87 | 22.62 | 12.32 | 9.94 | 16.0 |
| | ITHD average | 20.88 | | | 16.7 | | | 12.7 | | |

It is clear from Table 1 that the average ITHD values for both the healthy and rotor fault machine have almost the same value, and may be difficult to distinguish.

However the average ITHD values for stator winding faults and voltage unbalance as shown in table 2 are clearly distinguishable from the ITHD average values of the healthy machine. This indicates that the average ITHD of three phase currents can be used to perform a first level of diagnosis, if desired, to distinguish whether the fault exists on the stator side or on the rotor side.

Table 3 - Comparison of ITHD deviation of three phase current under healthy and stator winding fault conditions

| Load | ITHD / ITHD deviation | Healthy | | | Stator winding fault | | | | | |
|---|---|---|---|---|---|---|---|---|---|---|
| | | | | | Fault severity 5.5% | | | Fault severity 6.6% | | |
| | | $i_a$ | $i_b$ | $i_c$ | $i_a$ | $i_b$ | $i_c$ | $i_a$ | $i_b$ | $i_c$ |
| 25% | ITHD | 18.69 | 22.00 | 20.05 | 14.95 | 10.26 | 21.35 | 13.85 | 9.72 | 20.98 |
| | ITHD deviation | 3.3 | | | 11 | | | 11.1 | | |
| 50% | ITHD | 18.62 | 19.64 | 23.51 | 15.34 | 11.21 | 22.32 | 13.53 | 9.48 | 20.82 |
| | ITHD deviation | 4.9 | | | 11.1 | | | 11.4 | | |
| 100% | ITHD | 20.19 | 19.58 | 22.86 | 15.71 | 11.87 | 22.62 | 16.17 | 11.11 | 23.99 |
| | ITHD deviation | 3.3 | | | 11.2 | | | 12.8 | | |

The experimental results in Table 3 above show the calculated ITHD values for the three phase currents, together with a value for the ITHD deviation. These values are shown for (a) a healthy machine, (b) a machine with a stator winding fault operated in two different fault severities such as 5.5%, and 6.6% of phase winding short circuited.

The ITHD deviation of the ITHD values is calculated by subtracting the minimum ITHD value from the maximum ITHD value respectively for each three phase currents.

So, for example, the ITHD deviation value for the healthy machine under 25% load is calculated as 22.00 - 18.69 = 3.3.

The calculated deviation of ITHD values for the three phase currents in Table 3 indicate that for stator winding fault the deviation is larger than for the healthy machine. Indeed, it is believed that for a stator winding fault the deviation increases with fault severity. In other words, when comparing the ITHD deviation for each given severity (5.5% and 6.6%) the ITHD deviation value increases progressively from the value determined for the healthy machine.

However, this can be contrasted with the determined values for the deviation of ITHD values for an induction machine operated under voltage unbalance, as given in Table 4 below, where it is indicated that the deviation of ITHD values decreases with increasing supply voltage unbalance. Voltage unbalance is characterized by reduced ITHD average value when compared to healthy machine and progressive decrease in the ITHD deviation value as the voltage unbalance severity increases. However, for a voltage unbalance of 4% the ITHD deviation value is comparable to the healthy value. Hence, a threshold is established to avoid discrepancies in differentiation of voltage unbalance from stator winding fault. A threshold value of 150% of minimum ITHD value of all the three phase is used. The reason for selecting 150% of minimum ITHD value of all the three phases of healthy machine is, due to asymmetry in winding and input supply unbalance of the ITHD values for all phases of the healthy machine will not be equal. From experimental results, it has been observed that there is a minimum difference of 32% between the minimum and maximum ITHD values for 50% load of healthy machine. Hence, a tolerance of 20% is given besides the normal difference (32%) to achieve reliable fault detection. The threshold of 150% is based on the healthy machine database hence, the threshold has to be appropriately calculated for each frequency and load condition. The threshold condition 150% is the boundary condition for reliable fault detection. In general, if the ITHD deviation value is less than 150% of minimum ITHD value of all the three phase the fault is considered as voltage unbalance. If the ITHD deviation is greater than 150% of minimum ITHD value of all the three phase the fault is considered as a stator winding fault.

Table 4 - Comparison of ITHD deviation of three phase current under healthy and voltage unbalance condition for various load conditions

| Load | ITHD / ITHD deviation | Healthy | | | Voltage Unbalance (VU) | | | | | |
|---|---|---|---|---|---|---|---|---|---|---|
| | | | | | *4% of VU* | | | *7% of VU* | | |
| | | $i_a$ $i_b$ | | $i_c$ | $i_a$ | $i_b$ | $i_c$ | $i_a$ | $i_b$ | $i_c$ |
| 25% | ITHD | 18.69 | 22.00 | 20.05 | 14.60 | 12.96 | 15.26 | 3.50 | 2.85 | 3.66 |
| | ITHD deviation | 3.3 | | | 3.4 | | | 0.81 | | |
| 50% | ITHD | 18.62 | 19.64 | 23.51 | 12.14 | 11.41 | 14.43 | 3.34 | 2.65 | 3.5 |
| | ITHD deviation | 4.9 | | | 4 | | | 0.85 | | |
| 100% | ITHD | 20.19 | 19.58 | 22.86 | 12.32 | 10.9 | 15.0 | 3.19 | 2.25 | 3.2 |
| | ITHD deviation | 3.3 | | | 4.1 | | | 0.95 | | |

*Example 1*

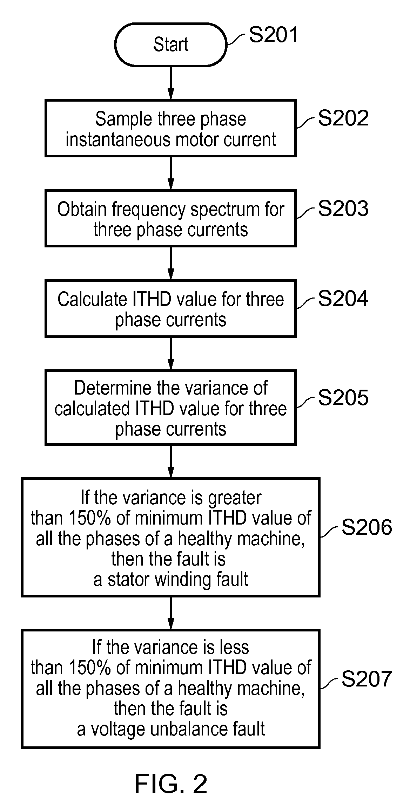

Figure 2 shows a method according to an aspect of the present disclosure applied to a motor supplied with three phase current. As mentioned above, the present disclosure is not limited to three phase current, and likewise the present disclosure is not limited to motors.

The process shown in Figure 2 may be a sub-process forming a portion of a more complex process.

The method begins at step S201, and in step S202 each of the three phase instantaneous motor currents is sampled. Respective signals indicative of the sampled currents are preferably output by current measurement units, for example to the condition monitoring system shown in Figure 1.

At step S203 a respective frequency spectrum is generated for each of the sampled current phases. Each frequency spectrum may be generated by a FFT for example, but other transformation operations are possible.

At step S204, ITHD values for each of the current phases are calculated using the above equation and using the respective frequency spectra.

Preferably, as in all embodiments and aspects, the ITHD values are based on the magnitudes of the non-fundamental harmonic peaks in the spectrum which exceed a determined threshold. The threshold is typically determined to be a fraction or percentage of the magnitude of the peak of the fundamental harmonic. For example, the threshold may be 1 % of the fundamental harmonic, e.g. of a corresponding characteristic of the fundamental harmonic.

In step S204, for a three phase current, three ITHD values will be calculated. For an n-phase multiphase current, n ITHD values will preferably be calculated.

In step S205 the variance of ITHD values of all the phases is calculated. The calculated ITHD variance (based on the values measured in S202) is then compared with a pre-determined (or, reference healthy) ITHD value of a healthy induction machine.

Preferably, in all embodiments and examples, the reference healthy ITHD variance is obtained for the same machine when operating healthily and not experiencing any appreciable faults. However, the reference healthy ITHD variance may be obtained from a similar machine having similar characteristics to the machine under scrutiny.

In step S206 and S207, it is determined whether the calculated ITHD variance is greater than or less than the 150% of minimum ITHD value of all phases of healthy machine.

If the determination is that the calculated variance is greater than 150% of minimum ITHD value of all phases of healthy machine then it is judged that there may be a stator winding fault. The 150% of minimum ITHD value of all phases of healthy machine is based on the difference between minimum and maximum ITHD value of a healthy machine at corresponding frequency/ load condition. The threshold can be varied depending on the healthy dataset. For example, if the determination is that the calculated variance is greater than the reference healthy minimum ITHD value by a threshold amount (e.g. a first threshold amount), then it is judged that there is a stator winding fault.

Optionally, if the determination is that the calculated variance is less than 150% of minimum ITHD value of all phases of healthy machine then it is judged that there may be a voltage unbalance. For example, if the determination is that the calculated variance is less than the reference healthy minimum ITHD variance by a threshold amount (e.g. a second threshold amount), then it is judged that there is a voltage unbalance.

Optionally, if the determination is that the calculated variance is equal to the reference healthy ITHD variance then it may be judged that there is no stator side fault, for example it may be judged that the machine is healthy. In particular, if the determination is that the calculated variance is greater than or less than the reference healthy ITHD variance by a threshold amount (e.g. a third threshold amount) then it may be judged that there is no stator side fault, for example it may be judged that the machine is healthy.

In embodiments, if the determination is that the calculated variance is not greater than the reference healthy ITHD variance by the first threshold amount, then it is judged that there is no stator winding fault, for example it may be judged that the machine is healthy.

In embodiments, if the determination is that the calculated variance is not less than the reference healthy ITHD variance by the second threshold amount, then it is judged that there is not a voltage unbalance, for example it may be judged that the machine is healthy.

The method may include the step of outputting the judgement. In the case of the determination of a fault, a fault alarm or fault signal may be generated to alert the user or operator of the machine that a fault exists. Details outlining the type of fault (e.g. stator winding fault, unbalanced voltage) may be included in the alarm or signal.

The above method (and a method described in the context of any other embodiment or aspect) may be repeated for alternative loads, and/or for alternative supply currents for example. Therefore, the final judgement on whether or not there is a fault, and/or the type of fault, may be made after the method has been repeated one or more times.

*Example 2*

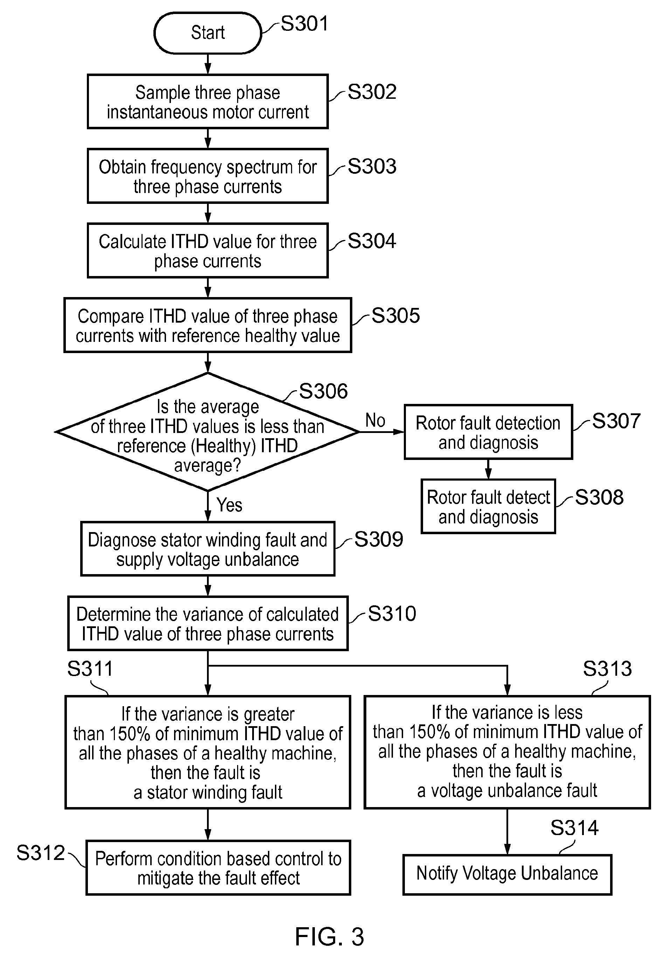

Figure 3 provides an overview of an example process of the present disclosure, including optional features.

In particular, Figure 3 shows a process optionally using the ITHD average values to diagnose and distinguish between stator side and rotor side fault, and then using the ITHD variation values to distinguish whether or not the fault is a stator winding fault or a supply voltage unbalance. Experimental results based on this process have confirmed that the stator winding fault with fault severity greater than 3% of phase winding short circuit and supply voltage unbalance greater than 2% can be reliably diagnosed.

The process shown in Figure 3 may be a sub-process forming a portion of a more complex process.

The method begins at step S301, and in step S302 each of the three phase instantaneous motor currents is sampled. Respective signals indicative of the sampled currents are preferably output by current measurement devices, for example to the condition monitoring system shown in Figure 1.

At step S303 a respective frequency spectrum is generated for each of the sampled current phases. Each frequency spectrum may be generated by a FFT for example, but other transformation operations are possible.

At step S304, ITHD values for each of the current phases are calculated using the above equation and using the respective frequency spectra.

Preferably, as in all embodiments and aspects, the ITHD values are based on the magnitudes of the non-fundamental harmonic peaks in the spectrum which exceed a determined threshold. The threshold is typically determined to be a fraction or percentage of the magnitude of the peak of the fundamental harmonic. For example, the threshold may be 1 % of the fundamental harmonic, e.g. of a corresponding characteristic of the fundamental harmonic.

In step S304, for a three phase current, three ITHD values will be calculated. For an n-phase multiphase current, n ITHD values will preferably be calculated.

In step S304, an ITHD average value for the calculated ITHD values is determined.

In step S305 the ITHD average value is compared with a corresponding pre-determined (reference healthy) ITHD average value for a healthy induction machine, preferably for the same machine when healthy and not experiencing any appreciable faults.

In step S306 it is determined whether the ITHD average value is less than the reference healthy ITHD average value.

If the determination in step S306 is that the ITHD average value is not less than the reference healthy ITHD average value, then a judgement is made at step S307 that the induction machine is likely to be healthy or to have a rotor side fault. In other words, a judgement is made that is it unlikely that there is a stator side fault. In particular, a judgement may be made that there is no stator side fault. Following step S307, an additional optional step S308 may be executed in which a rotor (side) fault detection and diagnosis sub-process is performed.

However, if the determination in step S306 is that the ITHD average value is less than the reference healthy ITHD average value, then a judgement is made at step S309 that there is likely to be a stator side fault. For example, a judgment may be made that there is likely to be a stator winding fault, and/or a supply voltage unbalance. In particular, a judgment may be made that there is a stator winding fault, and/or a supply voltage unbalance.

Subsequently, a sub-process generally similar to that described in Figure 2 is preferably performed.

For example, at step S310 the variance of ITHD values of all phases is calculated. The calculated ITHD variance (ultimately based on the values measured in S302) may then be compared with a pre-determined (or reference healthy) minimum ITHD value of a healthy induction machine, preferably for the same machine when healthy and not experiencing any appreciable faults.

In step S310, it is determined whether the calculated ITHD variance is greater than or less than the reference healthy minimum ITHD value (or the respective thresholds mentioned above with reference to Example 1).

If the determination is that the calculated variance is greater than 150% of minimum ITHD value of all phases of healthy machine then it is judged at step S311 that there may be a stator winding fault. For example, if the determination is that the calculated variance is greater than the reference healthy minimum ITHD variance value by a threshold amount (e.g. the first threshold amount), then it is judged that there is a stator winding fault.

Optionally, subsequent to step S311, and preferably based on the result of step S311, control may be exerted to mitigate the fault effect at S312.

If the determination at step S310 is that the calculated variance is less than 150% of minimum ITHD value of all phases of healthy machine then it is judged at step S313 that there may be a voltage unbalance. For example, if the determination is that the calculated variance is less than the reference healthy ITHD variance by a threshold amount (e.g. the second threshold amount), then it is judged that there is a voltage unbalance.

Optionally, subsequent to steps S313, at step S314, a notification may be issued that there is a voltage unbalance.

*Example 3*

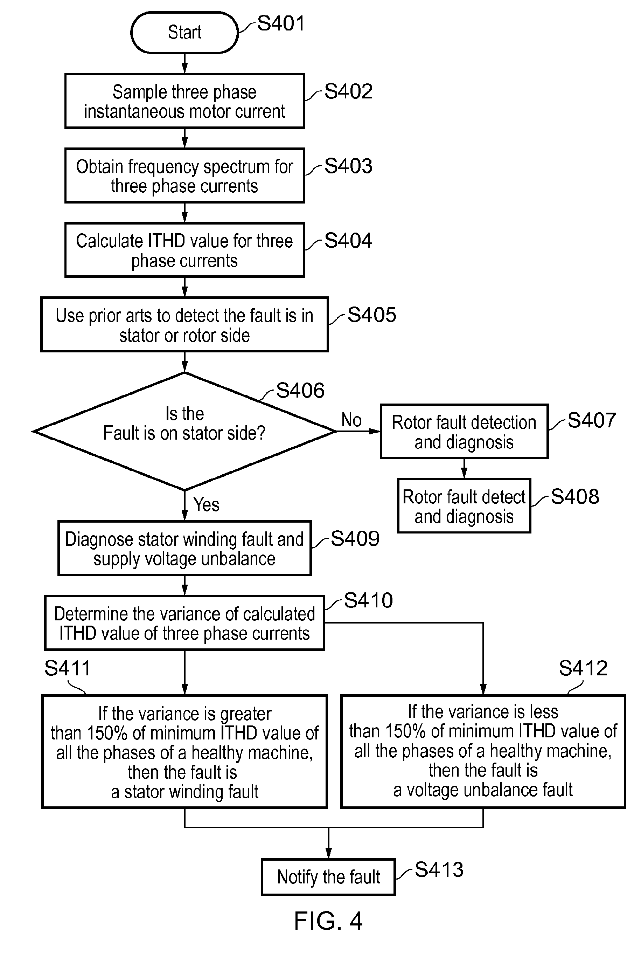

Figure 4 illustrates an overview of a further example method of the present disclosure, including optional features. The process shown in Figure 4 may be a sub-process forming a portion of a more complex process.

The method begins at step S401, and in step S402 each of the three phase instantaneous motor currents is sampled. Respective signals indicative of the sampled currents are preferably output by current measurement devices, for example to the condition monitoring system shown in Figure 1.

At step S403 a respective frequency spectrum is generated for each of the sampled current phases. Each frequency spectrum may be generated by a FFT for example, but other transformation operations are possible.

At step S404, ITHD values for each of the current phases are calculated using the aforementioned equation and using the respective frequency spectra. For a three phase current, three ITHD values will be calculated. For an n-phase multiphase current, n ITHD values will preferably be calculated.

Preferably, as in all embodiments and aspects, the ITHD values are based on the magnitudes of the non-fundamental harmonic peaks in the spectrum which exceed a determined threshold. The threshold is typically determined to be a fraction or percentage of the magnitude of the peak of the fundamental harmonic. For example, the threshold may be 1 % of the fundamental harmonic, e.g. of a corresponding characteristic of the fundamental harmonic.

In steps S405 and S406, a known technique for confirming the fault side is used. For example, first determining the magnitude of 2 times the fundamental component in the alpha beta spectrum or the Park vector spectrum. If the magnitude of 2 times the fundamental component is higher than the magnitude of 2 times the fundamental component of a healthy machine, then there is a stator anomaly. Otherwise the fault lies with the rotor side.

In step S407 a judgement is made that the induction machine has a rotor side fault. Following step S407, an additional optional step S408 may be executed in which a rotor (side) fault detection and diagnosis sub-process is performed.

However, if the determination in step S406 is that the induction machine has a fault on the stator side and/or a supply voltage unbalance, the subsequent steps define a sub-process generally similar to that described in Figure 2.

At step S410 the variance of ITHD values of all phases is calculated. The calculated ITHD variance (ultimately based on the values measured in S402) may then be compared with a pre-determined (or reference healthy) minimum ITHD value of a healthy induction machine, preferably for the same machine when healthy and not experiencing any appreciable faults. In step S410, it is determined whether the calculated ITHD variance is greater than or less than the reference healthy minimum ITHD value (or the respective thresholds mentioned above with reference to Example 1).

If the determination is that the calculated variance is greater than 150% of minimum ITHD value of all phases of healthy machine then it is judged at step S411 that there may be a stator winding fault. For example, if the determination is that the calculated variance is greater than the reference healthy minimum ITHD variance value by a threshold amount (e.g. the first threshold amount), then it is judged that there is a stator winding fault and this is notified to a user at step S413.

If the determination at step S410 is that the calculated variance is less than 150% of minimum ITHD value of all phases of healthy machine then it is judged at step S412 that there may be a voltage unbalance. For example, if the determination is that the calculated variance is less than the reference healthy ITHD variance by a threshold amount (e.g. the second threshold amount), then it is judged that there is a voltage unbalance.

Optionally, subsequent to step S412, at step S413, a notification may be issued that there is a voltage unbalance.

*Other comments*

Accordingly, the present disclosure discloses a method and system to detect and diagnose stator winding faults in multi-phase (polyphase) current induction machines whilst being able to distinguish the effects of voltage unbalance.

The proposed method(s) optionally provides a two steps process, in an optional first step the fault is diagnosed as stator side fault or rotor side fault (or no fault), and in a second stage the fault is determined to be either stator winding fault or supply voltage unbalance.

In the proposed method(s) only polyphase current measurements are required, whereas by contrast the conventional prior art detects and diagnoses stator winding faults on the basis of both voltage and current measurements.

The key benefit of the proposed solution is possibility of diagnose the stator winding fault at incipient state, which is important to improve the reliability of induction machines used in safety and mission critical application. As the induction machines are widely being used in applications such as marine and aerospace, the proposed solution able to improve the reliability and availability of the electrical system demanded by both these sectors.

The proposed solution can also be applicable to both high and low power machine used in any industrial applications. As the proposed solution relies only the current measurement it can be easily integrated with the existing variable speed drive used in any industrial application without any additional sensors. The proposed solution can also be used in other electrical machines such as permanent magnet synchronous machine and wound rotor synchronous machines.

An advantageous benefit of the present disclosure is the possibility to diagnose the stator winding fault at an incipient state, which is important to improve the reliability of induction machines used in safety and mission critical application. As induction machines are widely being used in various sectors such as marine and aerospace, the present disclosure is able to improve the reliability and availability of such electrical systems.

The present disclosure is applicable to both high and low power induction machines used in any industrial applications. As the proposed solution relies only the current measurement it can be easily integrated with the existing variable speed drives without the need to install any new additional sensors. The present disclosure can also be used in other electrical machines such as permanent magnet synchronous machine and wound rotor synchronous machines.

*Reference numerals used in the figures*

Condition monitoring system 10; induction machine 12; power supply/variable frequency drive 14; current meters/detectors 16; spectrum analyser unit 18; ITHD calculation unit 20; a record 22 of a corresponding ITHD calculation for a/the healthy induction machine; fault diagnosis and decision making unit 24.

**Claims**

1. A method of detecting a stator fault in a multi-phase current induction machine (12), the method comprising the steps of:

   obtaining a respective frequency spectrum for each of the current phases in the induction machine (12);
   deriving, from each frequency spectrum, a value for the ITHD (Inverse current Total Harmonic Distortion) for the respective current phase;
   calculating an ITHD deviation value corresponding to the maximum deviation for the derived ITHD values;
   judging whether the calculated ITHD deviation value differs from a reference deviation value; and
   determining, in response to a positive judgement, that there is a stator fault.

2. The method of detecting a stator fault in a multi-phase current induction machine (12) according to Claim 1 wherein in response to a judgement that the calculated ITHD deviation value is less than the reference deviation value, determining that the stator fault is a voltage unbalance.

3. The method of detecting a stator fault in a multi-phase current induction machine (12) according to Claim 2 wherein in response to a judgement that the calculated ITHD deviation value is less than the reference deviation value by a first threshold amount, determining that the stator fault is a voltage unbalance.

4. The method of detecting a stator fault in a multi-phase current induction machine (12) according to any one of Claims 1 to 3 wherein in response to a judgement that the calculated ITHD deviation value is greater than the reference deviation value, determining that the stator fault is a stator winding fault.

5. The method of detecting a stator fault in a multi-phase current induction machine (12) according to Claim 4 wherein in response to a judgement that the calculated ITHD deviation value is greater than the reference deviation value by a second threshold amount, determining that the stator fault is a stator winding fault.

6. The method of detecting a stator fault in a multi-phase current induction machine (12) according to Claim 4 or Claim 5 wherein in the stator winding fault includes a stator winding short circuit.

7. The method of detecting a stator fault in a multi-phase current induction machine (12) according to any one of Claims 1 to 6 wherein the step of deriving, from each frequency spectrum, a value for the ITHD for the respective current phase includes the step of calculating the ratio of the magnitude of the fundamental harmonic peak to the sum of the squared value of the magnitudes of selected non-fundamental harmonic peaks of the frequency spectrum.

8. The method of detecting a stator fault in a multi-phase current induction machine (12) according to any one of the preceding Claims further including the steps of
   generating an average ITHD value on the basis of the derived ITHD value, and judging whether the generated average ITHD value is less than a reference average value; and
   determining, in response to a positive judgement, that there is a stator fault; and optionally determining in response to a negative judgement that there is a rotor fault and/or the induction machine (12) is healthy.

9. The method of detecting a stator fault in a multi-phase current induction machine (12) according to any one of the preceding Claims, wherein the step of obtaining the frequency spectra includes the step of generating each frequency spectrum on the basis of an obtained signal indicative of a respective phase current of the multi-phase currents in the induction machine (12).

10. The method of detecting a stator fault in a multi-phase current induction machine (12) according to Claim 9 wherein the obtained signal is obtained from a measuring device measuring the respective phase current.

11. The method of detecting a stator fault in a multi-phase current induction machine (12) according to any one of the preceding Claims, wherein the reference deviation value is the calculated ITHD deviation value for the same induction machine (12) when experiencing no stator faults.

12. The method of detecting a stator fault in a multi-phase current induction machine (12) according to any one of the preceding claims as dependent on Claim 8, wherein the reference average value is the generated average ITHD value for the same induction machine (12) when experiencing no stator faults.

FIG. 1

```
           ╭─────────────╮
           │    Start     │──⟋ S201
           ╰─────────────╯
                  │
                  ▼
     ┌─────────────────────────┐
     │    Sample three phase    │──⟋ S202
     │ instantaneous motor current │
     └─────────────────────────┘
                  │
                  ▼
     ┌─────────────────────────┐
     │  Obtain frequency spectrum for │──⟋ S203
     │     three phase currents  │
     └─────────────────────────┘
                  │
                  ▼
     ┌─────────────────────────┐
     │ Calculate ITHD value for three │──⟋ S204
     │      phase currents       │
     └─────────────────────────┘
                  │
                  ▼
     ┌─────────────────────────┐
     │   Determine the variance of │──⟋ S205
     │ calculated ITHD value for three │
     │      phase currents       │
     └─────────────────────────┘
                  │
                  ▼
     ┌─────────────────────────┐
     │     If the variance is greater │
     │ than 150% of minimum ITHD value of │──⟋ S206
     │  all the phases of a healthy machine, │
     │        then the fault is     │
     │       a stator winding fault  │
     └─────────────────────────┘
                  │
                  ▼
     ┌─────────────────────────┐
     │       If the variance is less │
     │ than 150% of minimum ITHD value of │──⟋ S207
     │  all the phases of a healthy machine, │
     │        then the fault is     │
     │      a voltage unbalance fault │
     └─────────────────────────┘
```

FIG. 2

FIG. 3

```
            Start                  S401

    Sample three phase            S402
  instantaneous motor current

  Obtain frequency spectrum for   S403
      three phase currents

   Calculate ITHD value for three  S404
         phase currents

  Use prior arts to detect the fault is in  S405
       stator or rotor side

            Is the                 S406
      Fault is on stator side?  ──No──▶  Rotor fault detection   S407
                                            and diagnosis
            │Yes
                                         Rotor fault detect     S408
  Diagnose stator winding fault and  S409    and diagnosis
      supply voltage unbalance

  Determine the variance of calculated  S410
   ITHD value of three phase currents

  S411                                    S412

  If the variance is greater        If the variance is less
  than 150% of minimum ITHD value of  than 150% of minimum ITHD value of
  all the phases of a healthy machine,  all the phases of a healthy machine,
         then the fault is              then the fault is
      a stator winding fault        a voltage unbalance fault

             Notify the fault      S413
```

FIG. 4

Europäisches
Patentamt
European
Patent Office
Office européen
des brevets

# EUROPEAN SEARCH REPORT

**Application Number**

EP 16 15 0194

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 8 362 732 B2 (ANWAR MOHAMMAD N [US] ET AL) 29 January 2013 (2013-01-29)<br>* column 1, line 6 - line 47 *<br>* column 5, line 39 - column 6, line 5 *<br>* figures 2,3 *<br>----- | 1-12 | INV.<br>G01R31/34<br><br>ADD.<br>G01R23/20 |
| A | ROSHANFEKR REZA ET AL: "Performance analysis of 3-phase wound rotor induction motor under asymmetrical fault conditions in stator and rotor windings",<br>THE 5TH ANNUAL INTERNATIONAL POWER ELECTRONICS, DRIVE SYSTEMS AND TECHNOLOGIES CONFERENCE (PEDSTC 2014), IEEE,<br>5 February 2014 (2014-02-05), pages 323-328, XP032587016,<br>DOI: 10.1109/PEDSTC.2014.6799394<br>[retrieved on 2014-04-16]<br>* page 327, column 1 - page 328, column 1 *<br>----- | 1-12 | |
| A | EP 1 591 795 A1 (ATEC CO LTD [JP])<br>2 November 2005 (2005-11-02)<br>* abstract; figure 4 *<br>----- | 1-12 | **TECHNICAL FIELDS SEARCHED (IPC)**<br><br>G01R |

The present search report has been drawn up for all claims

| Place of search | Date of completion of the search | Examiner |
|---|---|---|
| Munich | 20 June 2016 | Hof, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 15 0194

This annex lists the patent family members relating to the patent documents cited in the above-mentioned European search report.
The members are as contained in the European Patent Office EDP file on
The European Patent Office is in no way liable for these particulars which are merely given for the purpose of information.

20-06-2016

| Patent document cited in search report | | Publication date | Patent family member(s) | Publication date |
|---|---|---|---|---|
| US 8362732 | B2 | 29-01-2013 | NONE | |
| EP 1591795 | A1 | 02-11-2005 | EP 1591795 A1 | 02-11-2005 |
| | | | HK 1087778 A1 | 14-08-2009 |
| | | | JP 3661155 B2 | 15-06-2005 |
| | | | KR 20050044320 A | 12-05-2005 |
| | | | US 2006009932 A1 | 12-01-2006 |
| | | | WO 2004070402 A1 | 19-08-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8135551 B
- US 5514978 A
- US 6640196 B